# EUROPÄISCHE PATENTANMELDUNG

(11) **EP 3 799 536 A1**
(43) Veröffentlichungstag der Anmeldung: **31.03.2021**
(21) Anmeldenummer: 19200067.7
(22) Anmeldetag: 27.09.2019
(51) Int. Cl.: H05K 1/02, H05K 3/00, H05K 1/14, H05K 1/03, H05K 3/22

(54) **TRÄGER FÜR ELEKTRISCHE BAUELEMENTE UND ELEKTRONIKMODUL**

(71) Anmelder: Siemens Aktiengesellschaft, 80333 München (DE)
(72) Erfinder: Namyslo, Lutz, 91353 Hausen (DE); Nährig, Matthias, 91085 Weisendorf (DE); Panicerski, Stanislav, 90449 Nürnberg (DE)

(57) **Zusammenfassung**

Die Erfindung betrifft einen Träger (3) für wenigstens ein elektrisches Bauelement (5 bis 7). Der Träger (3) umfasst einen Kühlkörper (9) mit einer Kühlkörperoberfläche (31) und auf einer der Kühlkörperoberfläche (31) gegenüberliegenden Seite angeordneten Kühlrippen (27), eine auf der Kühlkörperoberfläche (31) angeordnete Trägerstruktur (15) für das wenigstens eine elektrische Bauelement (5 bis 7) und eine auf der Kühlkörperoberfläche (31) angeordnete Leiterplatte (13), die im Bereich der Trägerstruktur (15) wenigstens eine Leiterplattenausnehmung (39) aufweist, in der wenigstens ein elektrisches Bauelement (5 bis 7) auf der Trägerstruktur (15) anordenbar ist.

## Beschreibung

Die Erfindung betrifft einen Träger für wenigstens ein elektrisches Bauelement und ein Elektronikmodul.

Ein Elektronikmodul mit Leistungshalbleitern wie IGBT (Bipolartransistoren mit isolierter Gate-Elektrode, engl. Insulated-gate bipolar transistors) oder MOSFET (Metall-Oxid-Halbleiter-Feldeffekttransistoren, engl. metal-oxide-semiconductor field-effect transistors) wird in der Regel gekühlt, um die Leistungshalbleiter und weitere temperaturempfindliche Komponenten vor einer Überhitzung zu schützen. Dazu weist das Elektronikmodul beispielsweise einen wassergekühlten Kühlkörper auf, der unterhalb der Leistungshalbleiter angeordnet ist. Die Leistungshalbleiter sind dabei in der Regel in einem Gehäuse auf einer Bodenplatte angeordnet, die wiederum auf dem Kühlkörper angeordnet ist. In dem Gehäuse ist in der Regel außerdem wenigstens eine Leiterplatte mit Leiterbahnen und weiteren elektrischen Bauelementen wie elektronischen Schaltungen zum Ansteuern der Leistungshalbleiter angeordnet, beispielsweise auf den Leistungshalbleitern. Dieser komplexe Aufbau eines Elektronikmoduls erfordert einen relativ großen Bauraum, zumal an dem Gehäuse zusätzlicher Platz für Bondbalkone, Pins und Schraubverbindungen benötigt wird. Ferner bleibt in dem Gehäuse in der Regel Bauraum ungenutzt, beispielsweise Zwischenräume zwischen der Leiterplatte und dem Kühlkörper um die Leistungshalbleiter herum. In verschiedenen technischen Bereichen, beispielsweise auf dem Gebiet von Antriebsumrichtern, wachsen die Anforderungen an die Leistungsdichte von elektrischen Bauelementen wie Leistungshalbleitern und damit an eine effiziente Nutzung dafür vorhandenen Bauraums.

Der Erfindung liegt die Aufgabe zugrunde, Elektronikmodule insbesondere hinsichtlich ihres Bauraums zu verbessern.

Die Aufgabe wird erfindungsgemäß durch einen Träger für wenigstens ein elektrisches Bauelement mit den Merkmalen des Anspruchs 1 und ein Elektronikmodul mit den Merkmalen des Anspruchs 13 gelöst.

Vorteilhafte Ausgestaltungen der Erfindung sind Gegenstand der Unteransprüche.

Ein erfindungsgemäßer Träger für wenigstens ein elektrisches Bauelement umfasst einen Kühlkörper mit einer Kühlkörperoberfläche und auf einer der Kühlkörperoberfläche gegenüberliegenden Seite angeordneten Kühlrippen, eine auf der Kühlkörperoberfläche angeordnete Trägerstruktur für das wenigstens eine elektrische Bauelement und eine auf der Kühlkörperoberfläche angeordnete Leiterplatte, die im Bereich der Trägerstruktur wenigstens eine Leiterplattenausnehmung aufweist, in der wenigstens ein elektrisches Bauelement auf der Trägerstruktur anordenbar ist.

Ein erfindungsgemäßer Träger dient dazu, die Komplexität von Elektronikmodulen zu reduzieren, indem Funktionen von Bauteilen herkömmlicher Elektronikmodule von dem Träger übernommen werden und dadurch Bauteile eingespart und umverteilt werden, so dass insbesondere Bauraum eingespart und effizienter genutzt werden kann. Insbesondere ermöglicht die Erfindung die Fertigung eines Elektronikmoduls mit Leistungshalbleitern ohne ein Modulgehäuse, wodurch die Aufbauhöhe des Elektronikmoduls vorteilhaft reduziert wird, die Investitionskosten in Spritzgusswerkzeuge erheblich verringert werden (da kein Gehäuse hergestellt werden muss) und die Pin-Bestückung des Gehäuses völlig entfällt. Ferner ist keine Bodenplatte für das Elektronikmodul mehr erforderlich, da deren Funktion von dem Kühlkörper übernommen wird. Damit entfällt auch die relativ aufwändige Herstellung der Bodenplatte, die mehrere Iterationsschleifen zur Ermittlung der optimalen Vorbiegung der Bodenplatte umfasst. Die direkt auf der Kühlkörperoberfläche angeordnete Trägerstruktur ermöglicht eine verbesserte Entwärmung auf der Trägerstruktur angeordneter elektrischer Bauelemente und ermöglicht dadurch eine höhere Belastbarkeit der elektrischen Bauelemente und/oder eine verlängerte Lebensdauer der elektrischen Bauelemente. Insbesondere wird keine sonst übliche Wärmeleitpaste benötigt und damit entfällt auch die Gefahr, dass Wärmeleitpaste im Laufe der Zeit bei starker Lastwechselbeanspruchung aus dem Bereich zwischen dem Kühlkörper und der Trägerstruktur herausgepumpt wird und sich dadurch die Entwärmung der elektrischen Bauelemente verschlechtert.

Bei einer Ausgestaltung der Erfindung weist der Kühlkörper einen Grundkörper und eine die Kühlkörperoberfläche ausbildende metallische Wärmespreizschicht auf. Beispielsweise ist der Grundkörper aus Aluminium gefertigt und die Wärmespreizschicht ist aus Kupfer, Nickel, Silber oder aus Kupfer, Nickel oder Silber enthaltenden Legierung gefertigt. Durch die zwischen dem Grundkörper und der Trägerstruktur angeordnete Wärmespreizschicht wird die Entwärmung auf der Trägerstruktur angeordneter elektrischer Bauelemente weiter verbessert. Aluminim eignet sich aufgrund seiner hohen Wärmeleitfähigkeit und relativ geringen Kosten als Material des Grundkörpers.

Bei einer zur vorgenannten Ausgestaltung alternativen Ausgestaltung der Erfindung ist der Kühlkörper aus Kupfer gefertigt. Aufgrund der besonders hohen Wärmeleitfähigkeit von Kupfer ist dann keine zusätzliche Wärmespreizschicht erforderlich. Allerdings ist ein aus Kupfer gefertigter Kühlkörper teurer und schwerer als ein Kühlkörper mit einem Grundkörper aus Aluminium und einer Wärmespreizschicht.

Bei einer weiteren Ausgestaltung der Erfindung besteht die Trägerstruktur aus mehreren voneinander beabstandeten Strukturbereichen und die Leiterplatte weist für jeden Strukturbereich eine Leiterplattenausnehmung auf. Beispielsweise sind je zwei benachbarte Strukturbereiche in einem Abstand von 2 mm bis 20 mm voneinander angeordnet. Ferner kann auf der Leiterplatte in wenigstens einem Bereich zwischen zwei benachbarten Leiterplattenausnehmungen wenigstens ein mit einem elektrischen Bauelement verbindbarer Bondanschluss und/oder wenigstens eine mit einem elektrischen Bauelement verbindbare Leiterbahn angeordnet sein. Durch die Aufteilung der Trägerstruktur auf mehrere Strukturbereiche werden die einzelnen Bereiche der Trägerstruktur thermisch voneinander entkoppelt, so dass die Entwärmung auf der Trägerstruktur angeordneter elektrischer Bauelemente weiter verbessert wird. Das Anordnen von Bondanschlüssen und/oder Leiterbahnen in Bereichen der Leiterplatte zwischen den Leiterplattenausnehmungen nutzt diese Bereiche vorteilhaft zum Verschalten elektrischer Bauelemente. Alle Strukturbereiche können dabei auf kürzestem Weg und symmetrisch beispielsweise mit Zwischenkreisleiterbahnen auf der Leiterplatte für einen elektrischen Zwischenkreis verbunden werden. Schaltüberspannungen bedingt durch parasitäre Induktivitäten sind damit für alle Strukturbereiche gleich. Das ist ein entscheidender Vorteil beispielsweise gegenüber dreiphasigen Standardelektronikmodulen, bei denen eine mittlere Phase immer über die beiden äußeren Phasen mit dem Zwischenkreis verbunden wird.

Bei einer weiteren Ausgestaltung der Erfindung weist die Trägerstruktur ein abseitig der Kühlkörperoberfläche mit einer Kupferstruktur beschichtetes Keramiksubstrat auf. Die Trägerstruktur ist damit eine so genannte DCB-Struktur (DCB = direct bonded copper) mit einer Kupferstruktur zum elektrischen Verbinden, Aufbringen und Entwärmen auf der Trägerstruktur angeordneter elektrischer Bauelemente.

Bei weiteren Ausgestaltungen der Erfindung ist auf der Leiterplatte wenigstens ein elektrischer Anschluss zum externen elektrischen Kontaktieren wenigstens eines elektrischen Bauelements und/oder wenigstens eine elektronische Schaltung zum Ansteuern wenigstens eines elektrischen Bauelements, beispielsweise eines Leistungshalbleiters wie eines IGBT oder MOSFET, angeordnet. Da die Leiterplatte auf dem Kühlkörper aufgeordnet ist, können dadurch die elektrischen Anschlüsse und/oder elektronischen Schaltungen in dem Bauraum über dem Kühlkörper angeordnet werden, der sonst ungenutzt bleibt, wenn die Leiterplatte beispielsweise oberhalb der Leistungshalbleiter angeordnet wird. Dadurch wird zum einen der Platzbedarf reduziert. Zum anderen werden die elektrischen Anschlüsse und/oder elektronischen Schaltungen auch sehr nahe an der Trägerstruktur für die elektrischen Bauelemente angeordnet und somit können elektrische Verbindungen und Signalwege, beispielsweise zwischen auf der Trägerstruktur angeordneten Leistungshalbleitern und deren Gate-Ansteuerungen, so kurz wie möglich realisiert werden. Damit werden parasitäre Impedanzen reduziert und die Ansteuerfunktionen stabiler ausgeführt (z. B. werden mögliche Schwingungsneigungen reduziert) .

Bei einer weiteren Ausgestaltung der Erfindung ist die Leiterplatte kühlkörperseitig elektrisch isoliert ausgeführt. Alternativ oder zusätzlich weist der Träger eine zwischen der Leiterplatte und der Kühlkörperoberfläche angeordnete elektrisch isolierende Isolierplatte, beispielsweise eine Kunststoffplatte, oder Isolierfolie, beispielsweise eine Kunststofffolie, auf, die für jede Leiterplattenausnehmung eine zu der Leiterplattenausnehmung korrespondierende Isolierausnehmung aufweist. Dadurch wird eine unerwünschte elektrische Verbindung von Bauelementen und Leiterbahnen auf der Leiterplatte über den Kühlkörper verhindert.

Ein erfindungsgemäßes Elektronikmodul umfasst einen erfindungsgemäßen Träger und wenigstens ein auf der Trägerstruktur des Trägers in einer Leiterplattenausnehmung der Leiterplatte des Trägers angeordnetes elektrisches Bauelement. Beispielsweise ist wenigstens ein elektrisches Bauelement ein Leistungshalbleiter-Bauelement, insbesondere ein Bipolartransistor mit isolierter Gate-Elektrode. Die Leiterplatte kann ferner wenigstens eine Leiterbahn aufweisen, die mit wenigstens einem auf der Trägerstruktur angeordneten elektrischen Bauelement elektrisch verbunden ist. Da ein erfindungsgemäßes Elektronikmodul einen erfindungsgemäßen Träger für die elektrischen Bauelemente des Elektronikmoduls aufweist, entsprechen die Vorteile eines erfindungsgemäßen Elektronikmoduls den oben genannten Vorteilen eines erfindungsgemäßen Trägers.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine Draufsicht auf ein Ausführungsbeispiel eines erfindungsgemäßen Elektronikmoduls,
- FIG 2: eine Schnittdarstellung des in Figur 1 gezeigten Elektronikmoduls,
- FIG 3: eine Draufsicht auf die Leiterplatte eines zweiten Ausführungsbeispiels eines erfindungsgemäßen Elektronikmoduls,
- FIG 4: eine Draufsicht auf die Leiterplatte eines dritten Ausführungsbeispiels eines erfindungsgemäßen Elektronikmoduls,
- FIG 5: eine Draufsicht auf die Leiterplatte eines vierten Ausführungsbeispiels eines erfindungsgemäßen Elektronikmoduls,
- FIG 6: eine Draufsicht auf die Leiterplatte eines fünften Ausführungsbeispiels eines erfindungsgemäßen Elektronikmoduls,
- FIG 7: eine Draufsicht auf die Leiterplatte eines sechsten Ausführungsbeispiels eines erfindungsgemäßen Elektronikmoduls,
- FIG 8: eine Draufsicht auf die Leiterplatte eines siebten Ausführungsbeispiels eines erfindungsgemäßen Elektronikmoduls,
- FIG 9: eine Draufsicht auf die Leiterplatte eines achten Ausführungsbeispiels eines erfindungsgemäßen Elektronikmoduls,
- FIG 10: eine Draufsicht auf die Leiterplatte eines neunten Ausführungsbeispiels eines erfindungsgemäßen Elektronikmoduls,
- FIG 11: eine Draufsicht auf die Leiterplatte eines zehnten Ausführungsbeispiels eines erfindungsgemäßen Elektronikmoduls.

Einander entsprechende Teile sind in den Figuren mit denselben Bezugszeichen versehen.

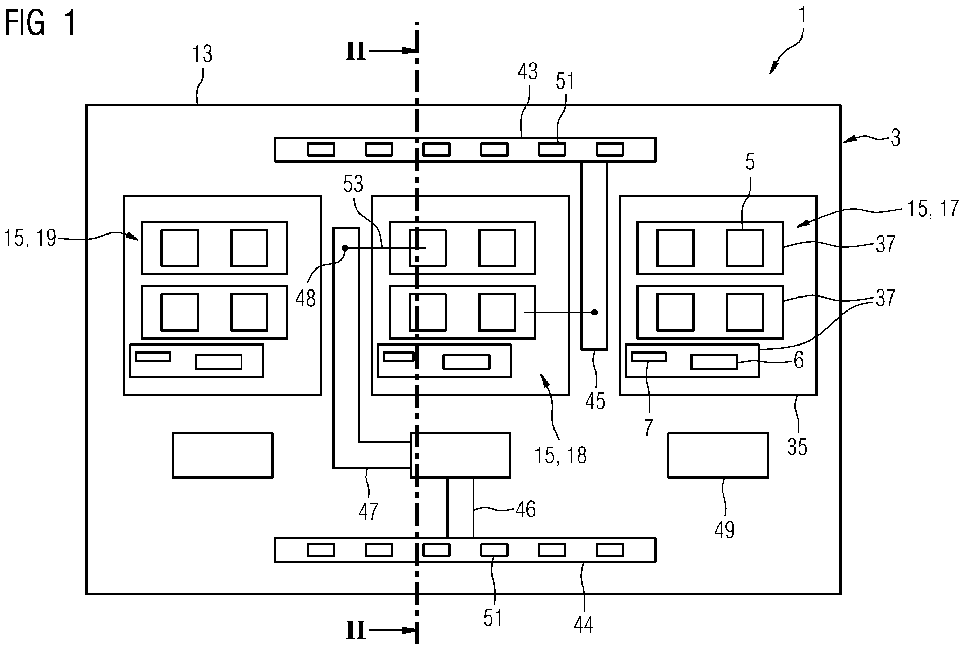

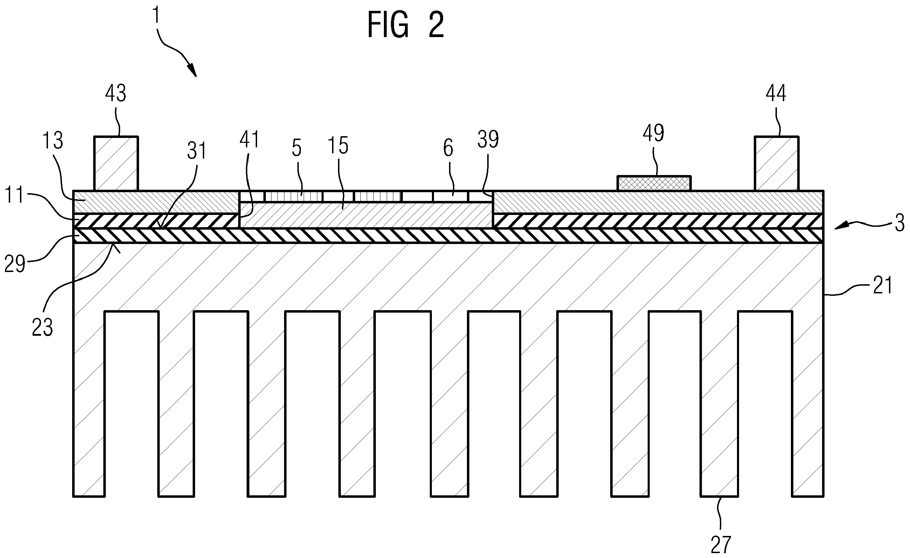

Figur 1 (FIG 1) und Figur 2 (FIG 2) zeigen ein erstes Ausführungsbeispiel eines erfindungsgemäßen Elektronikmoduls 1. Dabei zeigt Figur 1 eine Draufsicht auf das Elektronikmodul 1 und Figur 2 zeigt eine Schnittdarstellung des Elektronikmoduls 1.

Das Elektronikmodul 1 umfasst einen erfindungsgemäßen Träger 3 und elektrische Bauelemente 5 bis 7. Der Träger 3 umfasst einen Kühlkörper 9, eine Isolierplatte 11, eine Leiterplatte 13 und eine Trägerstruktur 15.

Der Kühlkörper 9 weist einen Grundkörper 21 auf, der oberseitig eine plane Grundkörperoberfläche 23 und unterseitig mehrere Kühlrippen 27 aufweist. Die Grundkörperoberfläche 23 ist zumindest unterhalb der Trägerstruktur 15 mit einer Wärmespreizschicht 29 beschichtet, die eine Kühlkörperoberfläche 31 ausbildet. Beispielsweise ist der Grundkörper 21 aus Aluminium durch Strangpressen hergestellt. Die Wärmespreizschicht 29 ist beispielsweise aus Kupfer, Nickel, Silber oder aus einer Kupfer, Nickel oder Silber enthaltenden Legierung gefertigt. Beispielsweise wird die Wärmespreizschicht 29 als ein in dem Strangpressprofil des Grundkörpers 21 integriertes Inlay hergestellt oder additiv, beispielsweise durch kaltgesprühte Beschichtung (Coldspray), Rührreibschweißen oder Plattieren, auf die Grundkörperoberfläche 23 aufgebracht. Alternativ wird der Kühlkörper 9 beispielsweise durch Umspritzen oder Umgießen der Wärmespreizschicht 29 mit Aluminium hergestellt.

Die Trägerstruktur 15 besteht aus drei Strukturbereichen 17 bis 19, die voneinander beabstandet auf der Kühlkörperoberfläche 31 angeordnet sind. In dem in Figur 1 gezeigten Ausführungsbeispiel sind die Strukturbereiche 17 bis 19 jeweils rechteckig ausgebildet und nebeneinander angeordnet. Beispielsweise sind je zwei benachbarte Strukturbereiche 17 bis 19 in einem Abstand von 2 mm bis 20 mm voneinander angeordnet. Jeder Strukturbereich 17 bis 19 weist ein auf der Kühlkörperoberfläche 31 aufliegendes Keramiksubstrat 35 auf, dessen von der Kühlkörperoberfläche 31 abgewandte Seite mit einer Kupferstruktur 37 beschichtet ist, die eine Leiterbahnstruktur und Kontaktflächen zum elektrischen Verbinden, Aufbringen und Entwärmen der elektrischen Bauelemente 5 bis 7 bildet. Die Trägerstruktur 15 ist eine so genannte DCB-Struktur mit dem Keramiksubstrat 35 als DCB-Substrat. Die Trägerstruktur 15 wird beispielsweise durch Löten oder Sintern auf die Kühlkörperoberfläche 31 aufgebracht.

Auf jedem Strukturbereich 17 bis 19 sind elektrische Bauelemente 5 bis 7 angeordnet. Unter den elektrischen Bauelementen 5 bis 7 sind beispielsweise Leistungshalbleiter-Bauelemente 5 wie ein IGBT oder MOSFET, Strommessshunts 6 und Temperatursensoren 7.

Die Isolierplatte 11 ist auf der Kühlkörperoberfläche 31 angeordnet. Die Leiterplatte 13 ist auf der Isolierplatte 11 angeordnet. Die Leiterplatte 13 weist für jeden Strukturbereich 17 bis 19 eine Leiterplattenausnehmung 39 auf, die den jeweiligen Strukturbereich 17 bis 19 einfasst. In alternativen Ausführungsbeispielen können die Strukturbereiche 17 bis 19 von der Leiterplatte 13 teilweise überdeckt sein. Die Isolierplatte 11 weist für jede Leiterplattenausnehmung 39 eine zu der Leiterplattenausnehmung 39 korrespondierende Isolierausnehmung 41 auf.

Auf der Leiterplatte 13 sind zwei Anschlussblöcke 43, 44, Leiterbahnen 45 bis 47, Bondanschlüsse 48 und elektronische Schaltungen 49 zum Ansteuern der Leistungshalbleiter-Bauelemente 5 angeordnet, wobei der Übersichtlichkeit halber nur einige Leiterbahnen 45 bis 47 dargestellt sind. Jeder Anschlussblock 43, 44 weist mehrere elektrische Anschlüsse 51 zum externen elektrischen Kontaktieren elektrischer Bauelemente 5 bis 7 auf. Unter den elektrischen Anschlüssen 51 eines ersten Anschlussblocks 43 sind beispielsweise Gleichspannungsleistungsanschlüsse, Phasenausgangsanschlüsse für eine Wechselspannung und Stromversorgungsanschlüsse. Unter den elektrischen Anschlüssen 51 des zweiten Anschlussblocks 44 sind beispielsweise Steuerungsanschlüsse für die Übertragung von Steuersignalen, beispielsweise um Soll- und Istwerte zum Steuern oder Regeln der Leistungshalbleiter-Bauelemente 5 zu übertragen. Die elektronische Schaltungen 49 umfassen beispielsweise Gate-Treiber für die Leistungshalbleiter-Bauelemente 5 und realisieren Potentialtrennungen. Einige Leiterbahnen 45, 46 verlaufen insbesondere in Bereichen der Leiterplatte 13 zwischen zwei benachbarten Leiterplattenausnehmungen 39. In diesen Bereichen der Leiterplatte 13 sind ferner insbesondere auch Bondanschlüsse 48 angeordnet. Elektrische Bauelemente 5 bis 7 sind insbesondere durch Bonddrähte 53, alternativ aber auch durch andere Verbindungen wie Kupferlaschen oder Brücken, mit Bondanschlüssen 48 und/oder Leiterbahnen 45 bis 47 der Leiterplatte 13 verbunden.

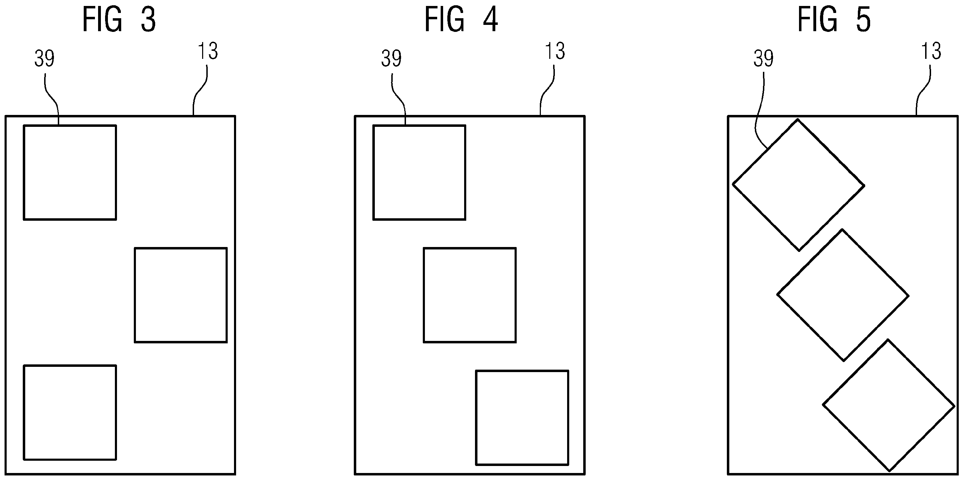

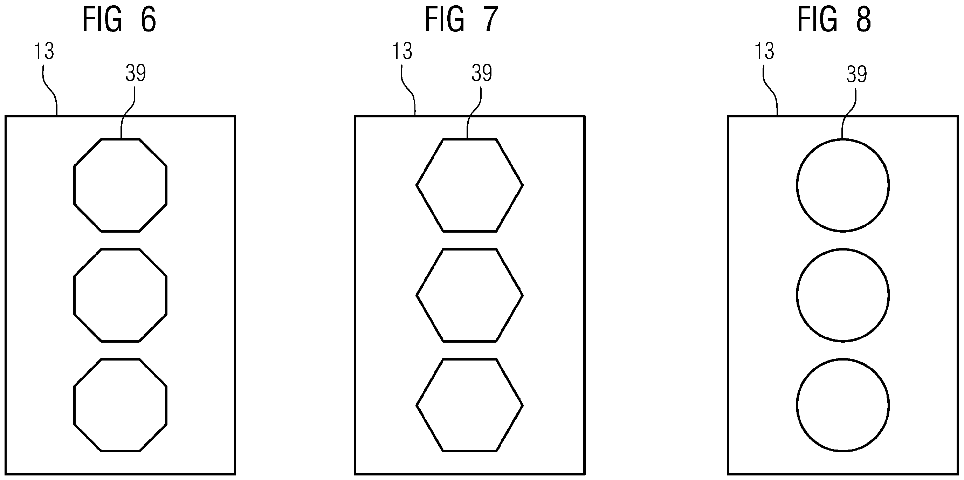

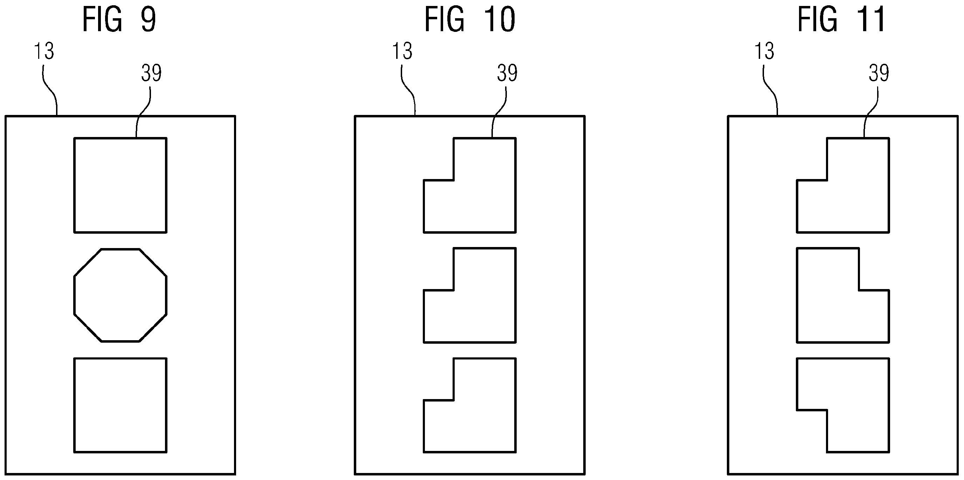

Die Figuren 3 bis 11 (FIG 3 bis FIG 11) zeigen jeweils eine Leiterplatte 13 eines weiteren Ausführungsbeispiels eines erfindungsgemäßen Elektronikmoduls 1, wobei auf der Leiterplatte 13 angeordnete elektrische Anschlüsse 51, elektronische Schaltungen 49, Leiterbahnen 45 bis 47 und Bondanschlüsse 48 nicht dargestellt sind. Diese Ausführungsbeispiele unterscheiden sich von dem in den Figuren 1 und 2 gezeigten Ausführungsbeispiel im Wesentlichen nur durch die Anordnung und/oder Form der Leiterplattenausnehmungen 39 sowie eine entsprechende Anordnung und/oder Form der Strukturbereiche 17 bis 19 und der Isolierausnehmungen 41. Die Figuren 3 bis 5 zeigen jeweils eine Leiterplatte 13 mit drei rechteckigen Leiterplattenausnehmungen 39, deren Verteilungen auf der Leiterplatte 13 sich voneinander und von dem in den Figuren 1 und 2 gezeigten Ausführungsbeispiel unterscheiden. Die in den Figuren 6 bis 11 gezeigten Leiterplatten 13 weisen jeweils drei nebeneinander angeordnete Leiterplattenausnehmungen 39 auf, die sich durch die Form und/oder Orientierung der Leiterplattenausnehmungen 39 voneinander unterscheiden. Die Leiterplattenausnehmungen 39 der in Figur 6 gezeigten Leiterplatte 13 sind jeweils achteckig, die Leiterplattenausnehmungen 39 der in Figur 7 gezeigten Leiterplatte 13 sind jeweils sechseckig, die Leiterplattenausnehmungen 39 der in Figur 8 gezeigten Leiterplatte 13 sind jeweils kreisförmig, die in Figur 9 gezeigte Leiterplatte 13 weist zwei rechteckige Leiterplattenausnehmungen 39 und eine dazwischen angeordnete achteckige Leiterplattenausnehmung 39 auf, Figur 10 zeigt eine Leiterplatte 13 mit drei gleich orientierten L-förmigen Leiterplattenausnehmungen 39 und Figur 11 zeigt eine Leiterplatte 13 mit drei verschieden orientierten L-förmigen Leiterplattenausnehmungen 39.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Träger (3) für wenigstens ein elektrisches Bauelement (5 bis 7), der Träger (3) umfassend
- einen Kühlkörper (9) mit einer Kühlkörperoberfläche (31) und auf einer der Kühlkörperoberfläche (31) gegenüberliegenden Seite angeordneten Kühlrippen (27),
- eine auf der Kühlkörperoberfläche (31) angeordnete Trägerstruktur (15) für das wenigstens eine elektrische Bauelement (5 bis 7) und
- eine auf der Kühlkörperoberfläche (31) angeordnete Leiterplatte (13), die im Bereich der Trägerstruktur (15) wenigstens eine Leiterplattenausnehmung (39) aufweist, in der wenigstens ein elektrisches Bauelement (5 bis 7) auf der Trägerstruktur (15) anordenbar ist.

2. Träger (3) nach Anspruch 1, wobei der Kühlkörper (9) einen Grundkörper (21) und eine die Kühlkörperoberfläche (31) ausbildende metallische Wärmespreizschicht (29) aufweist.

3. Träger (3) nach Anspruch 2, wobei der Grundkörper (21) aus Aluminium gefertigt ist und die Wärmespreizschicht (29) aus Kupfer, Nickel, Silber oder aus einer Kupfer, Nickel oder Silber enthaltenden Legierung gefertigt ist.

4. Träger (3) nach Anspruch 1, wobei der Kühlkörper (9) aus Kupfer gefertigt ist.

5. Träger (3) nach einem der vorhergehenden Ansprüche, wobei die Trägerstruktur (15) aus mehreren voneinander beabstandeten Strukturbereichen (17 bis 19) besteht und die Leiterplatte (13) für jeden Strukturbereich (17 bis 19) eine Leiterplattenausnehmung (39) aufweist.

6. Träger (3) nach Anspruch 5, wobei je zwei benachbarte Strukturbereiche (17 bis 19) in einem Abstand von 2 mm bis 20 mm voneinander angeordnet sind.

7. Träger (3) nach Anspruch 5 oder 6, wobei auf der Leiterplatte (13) in wenigstens einem Bereich zwischen zwei benachbarten Leiterplattenausnehmungen (39) wenigstens ein mit einem elektrischen Bauelement (5 bis 7) verbindbarer Bondanschluss (48) und/oder wenigstens eine mit einem elektrischen Bauelement (5 bis 7) verbindbare Leiterbahn (45 bis 47) angeordnet ist.

8. Träger (3) nach einem der vorhergehenden Ansprüche, wobei die Trägerstruktur (15) ein abseitig der Kühlkörperoberfläche (31) mit einer Kupferstruktur (37) beschichtetes Keramiksubstrat (35) aufweist.

9. Träger (3) nach einem der vorhergehenden Ansprüche, wobei auf der Leiterplatte (13) wenigstens ein elektrischer Anschluss (51) zum externen elektrischen Kontaktieren wenigstens eines elektrischen Bauelements (5 bis 7) angeordnet ist.

10. Träger (3) nach einem der vorhergehenden Ansprüche, wobei auf der Leiterplatte (13) wenigstens eine elektronische Schaltung (49) zum Ansteuern wenigstens eines elektrischen Bauelements (5 bis 7) angeordnet ist.

11. Träger (3) nach einem der vorhergehenden Ansprüche, wobei die Leiterplatte (13) kühlkörperseitig elektrisch isoliert ausgeführt ist.

12. Träger (3) nach einem der vorhergehenden Ansprüche mit einer zwischen der Leiterplatte (13) und der Kühlkörperoberfläche (31) angeordneten elektrisch isolierenden Isolierplatte (11) oder Isolierfolie, die für jede Leiterplattenausnehmung (39) eine zu der Leiterplattenausnehmung (39) korrespondierende Isolierausnehmung (41) aufweist.

13. Elektronikmodul (1), umfassend
- einen Träger (3) nach einem der vorhergehenden Ansprüche und
- wenigstens ein auf der Trägerstruktur (15) des Trägers (3) in einer Leiterplattenausnehmung (39) der Leiterplatte (13) des Trägers (3) angeordnetes elektrisches Bauelement (5 bis 7).

14. Elektronikmodul (1) nach Anspruch 13, wobei wenigstens ein elektrisches Bauelement (5 bis 7) ein Leistungshalbleiter-Bauelement (5), insbesondere ein Bipolartransistor mit isolierter Gate-Elektrode, ist.

15. Elektronikmodul (1) nach Anspruch 13 oder 14, wobei die Leiterplatte (13) wenigstens eine Leiterbahn (45 bis 47) aufweist, die mit wenigstens einem auf der Trägerstruktur (15) angeordneten elektrischen Bauelement (5 bis 7) elektrisch verbunden ist.
